# EUROPEAN PATENT APPLICATION

(11) **EP 4 597 839 A1**
(43) Date of publication of application: **06.08.2025**
(21) Application number: 24154575.5
(22) Date of filing: 30.01.2024
(51) Int. Cl.: H03K 3/57

(54) **AN ELECTRICAL PULSE GENERATING APPARATUS**

(71) Applicant: Nodica Group AB, 754 54 Uppsala (SE)
(72) Inventor: LINDSTRÖM, Johan, 754 54 UPPSALA (SE)
(74) Representative: AWA Sweden AB

(57) **Abstract**

An electrical pulse generating apparatus (100) is disclosed, comprising an electrical pulse generating unit (10) configured to generate one or more electrical pulses to be conveyed to a load (90), and a transformer (20) arranged such that any electrical pulse generated by the electrical pulse generating unit is conveyed to the load via the transformer, wherein the transformer has one or more primary windings, to which the electrical pulse generating unit is connected or connectable, and one or more secondary windings, to which the load is connected or connectable. The electrical pulse generating apparatus comprises an overvoltage protection unit (80) comprising an electrical energy storage unit (82) and circuitry (81) configured such that when the voltage on the one or more primary windings of the transformer is within a predefined threshold voltage range, the circuitry (81) conducts current therethrough in a first direction from the one or more primary windings of the transformer towards the electrical energy storage unit.

## Description

### TECHNICAL FIELD

The present invention generally relates to the field of electrical equipment. Specifically, the present invention relates to an electrical pulse generating apparatus.

### BACKGROUND

Electrical pulses may be employed in a variety of applications, such as, for example, radar systems, particle accelerators, sterilization equipment, high-energy lasers, microwave systems, or medical devices. In such and other applications it may be desired or required to deliver one or more electrical pulses to a load.

An electrical energy storage unit or module such as a capacitor may be used to store electrical energy, which when discharged generates an electrical pulse that can be delivered to the load, or to a pulse transformer. The capacitor may be repeatedly charged by a power supply unit or arrangement connected to a power source. The capacitor may be repeatedly or cyclically charged and discharged in order to generate a plurality of successive electrical pulses. Arrangements, apparatuses, systems or circuits which are employed for generating electrical pulses may be referred to as power modulators.

### SUMMARY

An electrical pulse generating unit in a power modulator may employ a power supply and an electrical energy storage unit that can be charged or discharged. The electrical energy storage unit may for example comprise a capacitor or several capacitors (e.g., a capacitor bank). Electrical pulses may be generated by repeatedly or cyclically charging and discharging the electrical energy storage unit, wherein when the electrical energy storage unit is discharged, an electrical pulse is generated which may be conveyed to, and received by, a transformer (e.g., a voltage step-up transformer) connected to a load. Possibly, the electrical pulse may be delivered or conveyed directly to the load. The electrical energy storage unit may be partially or completely charged and discharged. After the electrical energy storage unit has been discharged to generate an electrical pulse, the electrical energy storage unit should be charged again in preparation for any subsequent electrical pulse. In order to carry out the charging and discharging of the electrical energy storage unit, a switch or switching device may be included in the electrical pulse generating unit, which may selectively connect or disconnect a power supply with the electrical energy storage unit. The switch or switching device of an electrical pulse generating unit that is based on discharge of an electrical energy storage unit such as a capacitor may be referred to as a pulse switch or pulse switching device.

As mentioned in the foregoing, arrangements, apparatuses, systems or circuits which are employed for generating electrical pulses may be referred to as power modulators. As indicated in the foregoing, a power modulator may employ a pulse transformer in order to obtain the required or desired voltage of the electrical pulses. A pulse transformer may have one or more so-called primary windings and one or more so-called secondary windings, which may be referred to as "the primary" and "the secondary", respectively. A potential issue which may be associated with pulse transformers is accumulation of magnetizing energy in the pulse transformer. Accumulation of magnetizing energy in the pulse transformer may result in unwanted voltage spikes in the pulse transformer and/or in any component connected thereto, which may cause potential damage to the pulse transformer and the other component(s) connected to the transformer. This issue may be particularly pronounced in cases if and when an open circuit condition occurs in the pulse transformer's secondary side (i.e., the `side' of the transformer having the one or more so-called secondary windings). In such case, a building-up of magnetizing energy in the pulse transformer may occur, which may cause a rise in voltage in the primary winding(s) of the pulse transformer.

In view of the above, a concern of the present invention is to provide an electrical pulse generating apparatus, which may be based on discharge of an electrical energy storage unit such as a capacitor, and which includes a transformer arranged such that any generated electrical pulse is conveyed to a load via the transformer, which electrical pulse generating apparatus is capable of alleviating or even avoiding the above-described potential issue which may be associated with pulse transformers and by which a safe operation of the transformer can be facilitated or allowed.

To address at least one of this concern and other concerns, an electrical pulse generating apparatus in accordance with the independent claim is provided. Preferred embodiments are defined by the dependent claims.

According to a first aspect, an electrical pulse generating apparatus is provided. The electrical pulse generating apparatus is connected or connectable to a load. The electrical pulse generating apparatus comprises an electrical pulse generating unit, which is configured to generate one or more electrical pulses to be conveyed to the load. The electrical pulse generating apparatus comprises a transformer, which may be referred to as a pulse transformer. The transformer is arranged such that any electrical pulse generated by the electrical pulse generating unit is conveyed to the load via the transformer. The transformer has one or more primary windings, to which the electrical pulse generating unit is connected or connectable, and one or more secondary windings, to which the load is connected or connectable. The electrical pulse generating apparatus comprises an overvoltage protection unit. The overvoltage protection unit is connected in or to a current path between the electrical pulse generating unit and at least one primary winding of the one or more primary windings of the transformer. The overvoltage protection unit comprises an electrical energy storage unit. The overvoltage protection unit comprises circuitry configured such that (e.g., only) when the voltage over or on the one or more primary windings of the transformer is within a predefined threshold voltage range, the circuitry conducts current therethrough in a first direction from the one or more primary windings of the transformer towards the electrical energy storage unit of the overvoltage protection unit, and when the voltage over or on the one or more primary windings of the transformer is outside the predefined threshold voltage range, the circuitry conducts current therethrough only in a second direction opposite to the first direction.

As indicated in the foregoing, for example if and when an open circuit condition occurs in the transformer's secondary side (i.e., the `side' of the transformer having the secondary winding(s), a build-up of magnetizing energy in the transformer may occur, which in turn may cause a rise in voltage in or over the primary winding(s) of the transformer. Such a voltage rise may potentially cause damage to the transformer and any other component(s) connected thereto. The voltage rise may be such that the voltage over or on the one or more primary windings of the transformer becomes within the predefined threshold voltage range. By means of the said circuitry of the overvoltage protection unit being configured such that when the voltage over or on the one or more primary windings of the transformer is within a predefined threshold voltage range, the circuitry conducts current therethrough in the first direction from the one or more primary windings of the transformer towards the electrical energy storage unit of the overvoltage protection unit, and when the voltage over or on the one or more primary windings of the transformer is outside the predefined threshold voltage range, the circuitry conducts current therethrough only in the second direction opposite to the first direction, any magnetizing energy in the pulse transformer which may give rise to damage to the transformer and any other component(s) connected thereto may be (e.g., quickly) conveyed to and absorbed in the electrical energy storage unit of the overvoltage protection unit. By means of the configuration of the overvoltage protection unit - in particular by means of the said circuitry of the overvoltage protection unit - such magnetizing energy may be conveyed or channeled to the electrical energy storage unit of the overvoltage protection unit relatively quickly, possibly with a response time of a few nanoseconds or perhaps even less. The energy which is thereby stored in the electrical energy storage unit of the overvoltage protection unit may subsequently be dissipated in a safe manner over time.

The said circuitry of the overvoltage protection unit may be configured with a certain associated predefined threshold voltage range to ensure that certain potential conditions which may arise in the transformer and/or any other component(s) connected thereto can be alleviated or even avoided by means of the overvoltage protection unit. For example, there may be a limit on how large the voltage over or on the one or more primary windings of the transformer is allowed to be in order to avoid damage to the transformer and/or any other component(s) connected thereto. Such a limit may be referred to as a threshold voltage level. The circuitry of the overvoltage protection unit may in such a case be configured with an appropriate predefined threshold voltage range to ensure that if and when such a condition occurs, the circuitry conducts current therethrough in the first direction from the one or more primary windings of the transformer towards the electrical energy storage unit to avoid that the voltage over or on the one or more primary windings of the transformer exceeds the threshold voltage level.

Different configurations of the circuitry of the overvoltage protection unit are possible in order to implement or realize the above-described functionality of the overvoltage protection unit.

According to one implementation example in accordance with one or more embodiments of the present invention, the said circuitry of the overvoltage protection unit may comprise at least one diode which may be arranged such that for each diode, the anode of the diode is connected to the at least one primary winding of the one or more primary windings of the transformer. The at least one diode may be configured such that when the voltage on the one or more primary windings of the transformer is within the predefined threshold voltage range, the at least one diode becomes forward biased, whereby current is conducted therethrough in the first direction from the one or more primary windings of the transformer towards the electrical energy storage unit of the overvoltage protection unit. The at least one diode may for example comprise at least one Schottky diode.

According to another implementation example in accordance with one or more embodiments of the present invention, the said circuitry of the overvoltage protection unit may, in alternative or in addition, comprise at least one Zener diode which may be arranged such that for each Zener diode, the anode of the Zener diode is connected to the at least one primary winding of the one or more primary windings of the transformer. The predefined threshold voltage range may be defined by a value of a breakdown voltage of the at least one Zener diode.

The said circuitry of the overvoltage protection unit preferably comprises silicon carbide-based components or elements. For example, each or any diode of the said circuitry of the overvoltage protection unit preferably is a silicon carbide-based diode, or a diode at least in part based on silicon carbide. In the context of the present application, by a diode being at least in part based on silicon carbide, it is meant that the semiconductor component(s) of the diode is/are made partly or (substantially) completely of silicon carbide, or possibly of some material comprising silicon carbide.

Silicon carbide (SiC) is a compound semiconductor material comprising silicon and carbon. For example, compared to silicon, silicon carbide generally exhibits a much higher dielectric breakdown field strength and bandgap. Power electronics semiconductor devices based on silicon carbide may be able to withstand higher breakdown voltage, may have a lower resistivity, and may be able to operate at higher temperature compared to power electronics semiconductor devices based on silicon (but not silicon carbide). In particular, compared to diodes based on silicon, diodes based on silicon carbide may have a lower reverse recovery current and recovery time.

The electrical energy storage unit of the overvoltage protection unit may comprise one or more capacitors.

In the light of the foregoing description, the overvoltage protection unit may, in accordance with one or more embodiments of the present invention, be considered as being or including a capacitor-diode snubber device. For example in the event of a sudden open-circuit on the secondary, any magnetizing energy in the transformer which may give rise to damage to the transformer and any other component(s) connected thereto may be (e.g., quickly) channeled through, e.g., the at least one diode of the overvoltage protection unit so as to be conveyed to and absorbed in the electrical energy storage unit of the overvoltage protection unit, which may prevent voltage spikes and potential damage to the transformer and other component(s) connected thereto.

The one or more primary windings of the transformer may be directly connected or connectable to the electrical pulse generating unit, or indirectly connected or connectable to the electrical pulse generating unit (e.g., via one or more intermediate elements or components). The one more secondary windings of the transformer may be directly connected or connectable to the load, or indirectly connected or connectable to the load (e.g., via one or more intermediate elements or components).

The load may for example comprise or be constituted by one or more of a microwave amplifier, a klystron, a magnetron, or a particle emitter, such as, for example, an electron emitter (which may be referred to as an electron gun).

The overvoltage protection unit may be configured such that the electrical energy storage unit of the overvoltage protection unit is connected in parallel with the one or more primary windings of the transformer.

The electrical energy storage unit of the overvoltage protection unit may comprise an anode and a cathode. The overvoltage protection unit may be configured such that the anode of the electrical energy storage unit of the overvoltage protection unit is connected to ground.

The overvoltage protection unit may comprise a voltage source, which may be connected in parallel with the electrical energy storage unit of the overvoltage protection unit. The voltage source may be configured to maintain a constant voltage over the electrical energy storage unit of the overvoltage protection unit. The voltage source may be configured to maintain a constant voltage over the electrical energy storage unit of the overvoltage protection unit under 'normal' operation of the electrical pulse generating apparatus. `Normal' operation of the electrical pulse generating apparatus may be considered to be when there is no magnetizing energy flowing into the electrical energy storage unit as a result of, e.g., occurrence of an open-circuit event on the secondary as described herein. By maintaining a constant voltage over the electrical energy storage unit of the overvoltage protection unit, an increased stability in operation of the overvoltage protection unit may be achieved. In particular, it may help in achieving a predefined threshold voltage range associated with the overvoltage protection unit that has well-defined limits. For example with reference to the previously described example where the said circuitry of the overvoltage protection unit comprises at least one diode, an improved predictability of when (i.e., at which voltage level) the at least one diode becomes forward biased may be achieved. In the absence of the voltage source of the overvoltage protection unit, it might be needed for the electrical pulse generating unit to generate electrical pulses at a certain frequency in order to be able to maintain a desired constant voltage over the electrical energy storage unit of the overvoltage protection unit. By the provisioning of the voltage source, such a constraint may be mitigated or even avoided. The overvoltage protection unit may comprise a current limiting element which may be connected in parallel with the voltage source. The current limiting element may comprise a resistor and/or a diode, and/or some other type(s) of current limiting element.

The electrical pulse generating unit may comprise an electrical energy storage unit. The electrical pulse generating unit may comprise a power supply, which may be configured to selectively charge the electrical energy storage unit of the electrical pulse generating unit. The electrical pulse generating unit may be configured to generate one or more electrical pulses by charging and discharging of the electrical energy storage unit of the electrical pulse generating unit, wherein when the electrical energy storage unit of the electrical pulse generating unit is discharged, an electrical pulse may be created to be conveyed to the load.

The electrical pulse generating unit may comprise a switch unit (or switch, or switch element), which may be controllably switchable between at least a conducting state and a non-conducting state (or substantially non-conducting state). The switch unit may be connected to the power supply and to the electrical energy storage unit of the electrical pulse generating unit, respectively, such that the power supply charges the electrical energy storage unit of the electrical pulse generating unit by way of a charging current supplied by the power supply, or the electrical energy storage unit of the electrical pulse generating unit is discharged so as to create an electrical pulse to be conveyed to the load, based on switching of the at least one switch unit between at least the conducting state and the (e.g., substantially) non-conducting state thereof. For example, the switch unit may be electrically connected to the power supply and the electrical energy storage unit of the electrical pulse generating unit, respectively, such that when the switch unit is switched into the non-conducting state, the power supply charges the electrical energy storage unit of the electrical pulse generating unit by way of a charging current supplied by the power supply, and when the switch unit is switched into the conducting state, the electrical energy storage unit of the electrical pulse generating unit is discharged so as to create an electrical pulse to be conveyed to the load.

The power supply may for example comprise a power converter. For example, the power supply may comprise or be connectable to an Alternating Current (AC) source, and may further comprise a rectifier for converting AC from the AC source into Direct Current (DC) which can be used to charge the electrical energy storage unit of the electrical pulse generating unit.

In the context of the present application, by a non-conducting state of the switch unit it is meant a state where there is no or only very little conduction of current through the switch unit. Thus, the switch unit may be switchable so as to stop, or substantially stop, the switch unit from conducting current through the switch unit.

In the context of the present application, by a switch unit it is meant an electrical device or element which is capable of switching (parts or portions of) electrical signals or electrical power, and which may also be capable of attenuating or blocking and/or amplifying electrical signals or electrical power. The switch unit could in alternative - in accordance with one or more embodiments of the present invention - be referred to as a switching transistor element. The switch unit may for example be a power semiconductor-based switch unit. The switch unit may comprise at least one transistor or transistor device and/or another or other types of (e.g., power) semiconductor devices. The switch unit may for example comprise one or more solid-state semiconductor switching devices with turn-on and turn-off capability, such as, for example, at least one Insulated-Gate Bipolar Transistor (IGBT), Integrated Gate-Commutated Transistor (IGCT), metal oxide semiconductor field effect transistor (MOSFET) and/or gate turn-off thyristor (GTO), but is not limited thereto. According to another example, the switch unit may for example comprise or be constituted by one or more field-effect transistors (FETs), for example MOSFETs and/or junction gate FETs (JFETs).

The overvoltage protection unit may be connected between the switch unit and the transformer.

The electrical energy storage unit of the overvoltage protection unit might be referred to as a first electrical energy storage unit and the electrical energy storage unit of the electrical pulse generating unit might be referred to as a second electrical energy storage unit.

It is to be understood that while electrical energy storage unit(s) may be referred to herein as a capacitor, it is to be understood that more than one capacitor and/or another or other types of electrical energy storage units than capacitors may possibly be used, e.g., inductive electrical energy storage units. Thus, even if electrical energy storage unit(s) may be referred to herein as a capacitor, the disclosure herein is applicable in the same way or similarly for other types of electrical energy storage units than capacitors.

Thus, each or any of the electrical energy storage unit of the overvoltage protection unit and the electrical energy storage unit of the electrical pulse generating unit may comprise or be constituted by one or more capacitors. In alternative or in addition, each or any of the electrical energy storage unit of the overvoltage protection unit and the electrical energy storage unit of the electrical pulse generating unit may comprise or be constituted by another or other types of electrical energy storage units than capacitors, e.g., inductive electrical energy storage units.

According to a second aspect, a system is provided. The system comprises a load. The system comprises an electrical pulse generating apparatus according to the first aspect, which electrical pulse generating apparatus is connected to the load. As mentioned, the load may for example comprise or be constituted by one or more of a microwave amplifier, a klystron, a magnetron, or a particle emitter.

Further objects and advantages of the present invention are described in the following by means of exemplifying embodiments. It is noted that the present invention relates to all possible combinations of features recited in the claims. Further features of, and advantages with, the present invention will become apparent when studying the appended claims and the description herein. Those skilled in the art realize that different features of the present invention can be combined to create embodiments other than those described herein.

### BRIEF DESCRIPTION OF THE DRAWING

Exemplifying embodiments of the present invention will be described below with reference to the accompanying drawing.

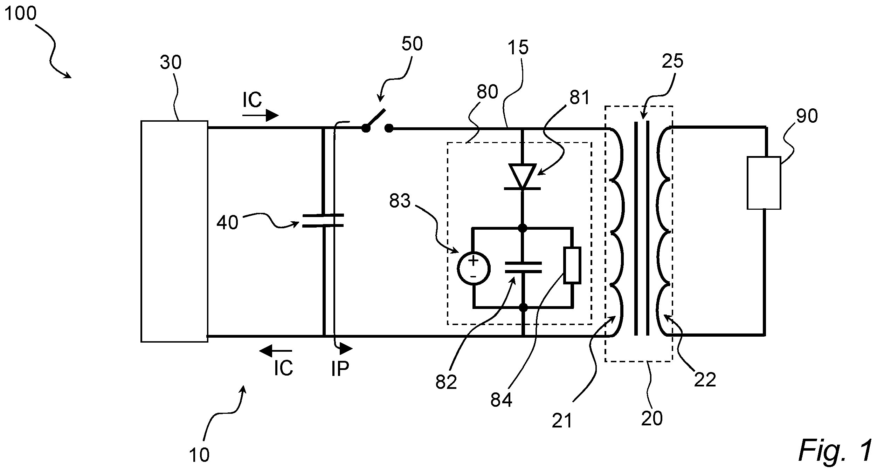

Figure 1 is a schematic circuit diagram of an electrical pulse generating apparatus according to embodiments of the present invention.

The figure is schematic, not necessarily to scale, and generally only show parts which are necessary in order to elucidate embodiments of the present invention, wherein other parts may be omitted or merely suggested.

### DETAILED DESCRIPTION

The present invention will now be described hereinafter with reference to the accompanying drawing, in which exemplifying embodiments of the present invention are shown. The present invention may, however, be embodied in many different forms and should not be construed as limited to the embodiments of the present invention set forth herein; rather, these embodiments are provided by way of example so that this disclosure will convey the scope of the present invention to those skilled in the art.

Figure 1 is a schematic view of an electrical pulse generating apparatus 100 according to an embodiment of the present invention. The electrical pulse generating apparatus 100 comprises an electrical pulse generating unit 10 that is connected (or connectable) to a load 90. The load 90 may for example comprise or be constituted by one or more of a microwave amplifier, a klystron, a magnetron, or a particle emitter, such as, for example, an electron emitter (which may be referred to as an electron gun).

The electrical pulse generating unit 10 is configured to generate one or more electrical pulses to be conveyed to the load 90. In accordance with the embodiment of the present invention illustrated in Figure 1, the electrical pulse generating unit 10 comprises an electrical energy storage unit 40, and a power supply 30, which is configured to selectively charge the electrical energy storage unit 40.

In accordance with the embodiment of the present invention illustrated in Figure 1, the electrical energy storage unit 40 comprises a capacitor. It is however to be understood that the electrical energy storage unit 40 could comprise several capacitors (e.g., a capacitor bank) and/or another or other types of electrical energy storage units than capacitors, e.g., inductive electrical energy storage units.

The power supply 30 may for example comprise a power converter. For example, the power supply may comprise or be connectable to an Alternating Current (AC) source (not shown in Figure 1) and may further comprise a rectifier (not shown in Figure 1) for converting AC from the AC source into Direct Current (DC) which can be used to charge the electrical energy storage unit 40. For example, the power supply 30 may be connectable or connected to a power source (not shown in Figure 1) that is supplying AC power, having one phase or a plurality of phases. The power source could for example be configured to supply three-phase AC power. The power source could for example comprise or be constituted by an electrical grid, which may supply three-phase AC power, e.g., mains electric power. The power supply 30 might comprise an input rectifier (not shown in Figure 1). The input rectifier may be is arranged to receive the AC power supplied by the power source when the power supply 30 is connected to the power source. The input rectifier may for example comprise or be constituted by a multi-phase rectifier, which may comprise a plurality of phase legs.

In accordance with the embodiment of the present invention illustrated in Figure 1, the electrical pulse generating unit 10 comprises a switch unit 50. The switch unit 50 may be configured such that the electrical conductivity of a current path through the switch unit 50 is controllable by transmission of a modulated (e.g., digital) drive signal to the switch unit 50. The switch unit 50 may be controllably switchable between different operational states thereof, for example by means of such a drive signal. The switch unit 50 may for example comprise one or more solid-state semiconductor switching devices with turn-on and turn-off capability, such as, for example, at least one Insulated-Gate Bipolar Transistor (IGBT), Integrated Gate-Commutated Transistor (IGCT), metal oxide semiconductor field effect transistor (MOSFET) and/or gate turn-off thyristor (GTO) but is not limited thereto. The switch unit 50 may for example comprise or be constituted by one or more IGBTs and/or MOSFETs (e.g., power MOSFETs).

The electrical pulse generating unit 10 is configured to generate one or more electrical pulses by charging and discharging of the electrical energy storage unit 40, wherein when the electrical energy storage unit 40 is discharged, at least a part of an electrical pulse is created to be conveyed to the load 90. The switch unit 50 is connected to the power supply 30 and to the electrical energy storage unit 40, respectively, such that the power supply 30 charges the electrical energy storage unit 40 by way of a charging current supplied by the power supply 30, or the electrical energy storage unit 40 is discharged so as to create an electrical pulse to be conveyed to the load 90, based on switching of the switch unit 50 between different operational states thereof.

In accordance with the embodiment of the present invention illustrated in Figure 1, the charging current that may be supplied by the power supply 30, based on switching of the switch unit 50 between different operational states thereof, may flow out of the power supply 30 via the conductor of the two conductors connected to the power supply 30 that is uppermost in Figure 1, and return to the power supply 30 via the conductor of the two conductors connected to the power supply 30 that is lowermost in Figure 1, as indicated by the arrows IC in Figure 1. The two above-mentioned conductors may for example be connected to two terminals of the power supply 30.

Further in accordance with the embodiment of the present invention illustrated in Figure 1, the current of an electrical pulse, which is generated when the electrical energy storage unit 40 is discharged, may for example flow in the direction indicated by the arrow IP in Figure 1. The electrical pulse generating unit 10 may for example be configured such that the duration of each or any electrical pulse that is generated is in a range from 0.5 µs to 25 µs, for example.

The electrical pulse generating apparatus 100 comprises a transformer 20, which is arranged such that any electrical pulse generated by the electrical pulse generating unit 10 is conveyed to the load 90 via the transformer 20. The transformer 20 comprises one or more primary windings 21, to which the electrical pulse generating unit 10 is connected or connectable, and one or more secondary windings 22, to which the load 90 is connected or connectable. The primary winding(s) of the transformer 20 may be configured to receive the electrical pulse(s) generated by the electrical pulse generating unit 10.

In accordance with the embodiment of the present invention illustrated in Figure 1 and as indicated therein, the transformer 20 may comprise four primary windings 21. However, it is to be understood that the number of primary windings 21 of the transformer 20 is not limited to four, but may for example be larger than four, or less than four. Further in accordance with the embodiment of the present invention illustrated in Figure 1 and as indicated therein, the transformer 20 may comprise four secondary windings 22. However, it is to be understood that the number of secondary windings 22 of the transformer 20 is not limited to four, but may for example be larger than four, or less than four.

The transformer 20 may comprise at least one core 25.

For example, the transformer 20 may be connected to the electrical pulse generating unit 10 by way of two terminals thereof, as illustrated in Figure 1.

As further illustrated in Figure 1, the transformer may be connected to the load 90 via the secondary winding(s) 22 of the transformer 20.

The electrical pulse generating apparatus 100 comprises an overvoltage protection unit 80, which is connected to a current path 15 between the electrical pulse generating unit 10 and at least one primary winding 21 of the one or more primary windings 21 of the transformer 20. As illustrated in Figure 1, the overvoltage protection unit 80 may be connected between the switch unit 50 and the transformer 20.

The overvoltage protection unit 80 comprises an electrical energy storage unit 82. In accordance with the embodiment of the present invention illustrated in Figure 1, the electrical energy storage unit 82 comprises a capacitor. It is however to be understood that the electrical energy storage unit 82 could comprise several capacitors (e.g., a capacitor bank) and/or another or other types of electrical energy storage units than capacitors, e.g., inductive electrical energy storage units.

The overvoltage protection unit 80 comprises circuitry 81. The circuitry 81 is configured such that when the voltage on the one or more primary windings 21 of the transformer 20 is within a predefined threshold voltage range, the circuitry 81 conducts current therethrough in a first direction from the one or more primary windings 21 of the transformer 20 towards the electrical energy storage unit 82 of the overvoltage protection unit 80, and when the voltage on the one or more primary windings 21 of the transformer 20 is outside the predefined threshold voltage range, the circuitry 81 conducts current therethrough only in a second direction opposite to the first direction. In accordance with the embodiment illustrated in Figure 1, the circuitry 81 is implemented by a diode, which is arranged such that the anode of the diode is connected to the at least one primary winding 21 of the one or more primary windings 21 of the transformer 20. The diode of the circuitry 81 is configured such that when the voltage on the one or more primary windings 21 of the transformer 20 is within the predefined threshold voltage range, the diode of the circuitry 81 becomes forward biased whereby current is conducted therethrough in the first direction, which first direction is from the one or more primary windings 21 of the transformer 20 towards the electrical energy storage unit 82 of the overvoltage protection unit 80. The diode of the circuitry 81 may comprise a Schottky diode, for example. On the other hand, when the voltage on the one or more primary windings 21 of the transformer 20 is outside the predefined threshold voltage range, the diode of the circuitry 81 is reverse biased, such that it the circuitry 81 conducts current therethrough only in the second direction, which is opposite to the first direction.

Thus, under 'normal' operation of the electrical pulse generating apparatus 100, wherein one or more electrical pulses are generated by the electrical pulse generating unit 10 to be conveyed to the load 90 via the transformer 20, the diode of the circuitry 81 may be reverse biased, thereby preventing the electrical energy storage unit 82 (e.g., a capacitor as illustrated in Figure 1) from affecting the operation of the transformer 20. However, if and when a sudden open-circuit event, for example, occurs on the secondary (i.e., the one or more secondary windings 22), the resulting magnetizing energy which may build up in the transformer 20 can induce a rise in voltage on the primary (i.e., the one or more primary windings 21). This voltage rise may forward-bias the diode of the circuitry 81. The forward-biasing of the diode of the circuitry 81 can create a path for the magnetizing energy to flow into the electrical energy storage unit 82, whereby the voltage on the primary may be reduced or limited by the magnetizing energy being stored in the electrical energy storage unit 82. The energy stored in the electrical energy storage unit 82 may subsequently be dissipated in a safe manner over time.

For the embodiment illustrated in Figure 1 according to which the circuitry 81 is implemented by a diode, the predefined threshold voltage range may depend on exactly how the diode is configured, such as on the particular (e.g., electrical) characteristics of the diode. Thus, circuitry 81 having a desired associated predefined threshold voltage range may be achieved by using constituent component(s) having certain or selected characteristics, for example using a diode which is configured so as to become forward biased at a certain voltage level.

It is to be understood that functionality of the circuitry 81, such as described in the foregoing, may be implemented in other ways. According to one example (not illustrated in Figure 1), the circuitry may, in alternative or in addition, comprise at least one Zener diode arranged such that for each Zener diode, the anode of the Zener diode is connected to the at least one primary winding 21 of the one or more primary windings 21 of the transformer 20. The predefined threshold voltage range may be defined by a value of a breakdown voltage of the at least one Zener diode.

The overvoltage protection unit 80 may comprise one or more additional, optional, components or elements. Two such optional components or elements are illustrated in Figure 1.

As illustrated in Figure 1, the overvoltage protection unit 80 may comprise a voltage source 83, which may be connected in parallel with the electrical energy storage unit 82 of the overvoltage protection unit 80. The voltage source 83 may be configured to maintain a constant voltage over the electrical energy storage unit 82 of the overvoltage protection unit 80, e.g., under 'normal' operation of the electrical pulse generating apparatus 100, when there is no magnetizing energy flowing into the electrical energy storage unit 82 as a result of, e.g., occurrence of an open-circuit event on the secondary such as described in the foregoing.

As illustrated in Figure 1, the overvoltage protection unit 80 may comprise a current limiting element 84, which may be connected in parallel with the voltage source 83. The current limiting element 84 may protect the voltage source 83 from damage, or at least reduce damage to the voltage source 83, in case of any currents in the overvoltage protection unit 80 having a magnitude for which the voltage source 83 is not rated or is not capable of handling without risk of damage to the voltage source 83. The current limiting element 84 may for example comprise one or more resistors and/or one or more diodes, and/or another or other types of current limiting elements.

In conclusion, an electrical pulse generating apparatus is disclosed. The electrical pulse generating apparatus comprises an electrical pulse generating unit configured to generate one or more electrical pulses to be conveyed to a load, and a transformer arranged such that any electrical pulse generated by the electrical pulse generating unit is conveyed to the load via the transformer. The transformer has one or more primary windings, to which the electrical pulse generating unit is connected or connectable, and one or more secondary windings, to which the load is connected or connectable. The electrical pulse generating apparatus comprises an overvoltage protection unit comprising an electrical energy storage unit and circuitry configured such that when the voltage on the one or more primary windings of the transformer is within a predefined threshold voltage range, the circuitry conducts current therethrough in a first direction from the one or more primary windings of the transformer towards the electrical energy storage unit.

While the present invention has been illustrated in the appended drawings and the foregoing description, such illustration is to be considered illustrative or exemplifying and not restrictive; the present invention is not limited to the disclosed embodiments. Other variations to the disclosed embodiments can be understood and effected by those skilled in the art in practicing the claimed invention, from a study of the drawings, the disclosure, and the appended claims. In the appended claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. An electrical pulse generating apparatus (100) connected or connectable to a load (90), the electrical pulse generating apparatus comprising:
an electrical pulse generating unit (10) configured to generate one or more electrical pulses to be conveyed to the load;
a transformer (20) arranged such that any electrical pulse generated by the electrical pulse generating unit is conveyed to the load via the transformer, wherein the transformer has one or more primary windings (21), to which the electrical pulse generating unit is connected or connectable, and one or more secondary windings (22), to which the load is connected or connectable; and
an overvoltage protection unit (80) connected to a current path (15) between the electrical pulse generating unit and at least one primary winding of the one or more primary windings of the transformer, the overvoltage protection unit comprising an electrical energy storage unit (82) and further circuitry (81) configured such that when the voltage on the one or more primary windings of the transformer is within a predefined threshold voltage range, the circuitry conducts current therethrough in a first direction from the one or more primary windings of the transformer towards the electrical energy storage unit of the overvoltage protection unit, and when the voltage on the one or more primary windings of the transformer is outside the predefined threshold voltage range, the circuitry conducts current therethrough only in a second direction opposite to the first direction.

2. An electrical pulse generating apparatus according to claim 1, wherein the overvoltage protection unit is configured such that the electrical energy storage unit of the overvoltage protection unit is connected in parallel with the one or more primary windings of the transformer.

3. An electrical pulse generating apparatus according to any one of claims 1-2, wherein the circuitry comprises at least one diode (81) arranged such that for each diode, the anode of the diode is connected to the at least one primary winding of the one or more primary windings of the transformer, and wherein the at least one diode is configured such that when the voltage on the one or more primary windings of the transformer is within the predefined threshold voltage range, the at least one diode becomes forward biased whereby current is conducted therethrough in the first direction from the one or more primary windings of the transformer towards the electrical energy storage unit of the overvoltage protection unit.

4. An electrical pulse generating apparatus according to claim 3, wherein the at least one diode comprises at least one Schottky diode.

5. An electrical pulse generating apparatus according to any one of claims 1-4, wherein the circuitry comprises at least one Zener diode arranged such that for each Zener diode, the anode of the Zener diode is connected to the at least one primary winding of the one or more primary windings of the transformer, and wherein the predefined threshold voltage range is defined by a value of a breakdown voltage of the at least one Zener diode.

6. An electrical pulse generating apparatus according to any one of claims 1-5, wherein the electrical energy storage unit of the overvoltage protection unit comprises an anode and a cathode, and wherein the overvoltage protection unit is configured such that the anode of the electrical energy storage unit of the overvoltage protection unit is connected to ground.

7. An electrical pulse generating apparatus according to any one of claims 1-6, wherein the electrical energy storage unit of the overvoltage protection unit comprises one or more capacitors.

8. An electrical pulse generating apparatus according to any one of claims 1-7, wherein the overvoltage protection unit further comprises a voltage source (83) connected in parallel with the electrical energy storage unit of the overvoltage protection unit.

9. An electrical pulse generating apparatus according to claim 8, wherein the voltage source is configured to maintain a constant voltage over the electrical energy storage unit of the overvoltage protection unit.

10. An electrical pulse generating apparatus according to any one of claims 8-9, wherein the overvoltage protection unit further comprises a current limiting element (84) connected in parallel with the voltage source.

11. An electrical pulse generating apparatus according to claim 10, wherein the current limiting element comprises at least one of a resistor and a diode.

12. An electrical pulse generating apparatus according to any one of claims 1-11, wherein the electrical pulse generating unit comprises:
an electrical energy storage unit (40); and
a power supply (30) configured to selectively charge the electrical energy storage unit of the electrical pulse generating unit;
wherein the electrical pulse generating unit is configured to generate one or more electrical pulses by charging and discharging of the electrical energy storage unit of the electrical pulse generating unit, wherein when the electrical energy storage unit of the electrical pulse generating unit is discharged, an electrical pulse is created to be conveyed to the load.

13. An electrical pulse generating apparatus according to claim 12, wherein the electrical pulse generating unit comprises:
a switch unit (50) controllably switchable between at least a conducting state and a non-conducting state, wherein the switch unit is connected to the power supply and to the electrical energy storage unit of the electrical pulse generating unit, respectively, such that the power supply charges the electrical energy storage unit of the electrical pulse generating unit by way of a charging current supplied by the power supply, or the electrical energy storage unit of the electrical pulse generating unit is discharged so as to create an electrical pulse to be conveyed to the load, based on switching of the at least one switch unit between at least the conducting state and the non-conducting state thereof.

14. An electrical pulse generating apparatus according to claim 13, wherein the overvoltage protection unit is connected between the switch unit and the transformer.

15. A system (100, 90) comprising a load (90) and an electrical pulse generating apparatus (100) according to any one of claims 1-14 connected to the load.
